# EUROPEAN PATENT APPLICATION

(11) **EP 4 207 283 A1**
(43) Date of publication of application: **05.07.2023**
(21) Application number: 21218440.2
(22) Date of filing: 31.12.2021
(51) Int. Cl.: H01L 27/02

(54) **A SEMICONDUCTOR DEVICE**

(71) Applicant: Nexperia B.V., 6534 AB Nijmegen (NL)
(72) Inventor: Mintzlaff, Rainer, 22529 Hamburg (DE); Ritter, Hans-Martin, 22529 Hamburg (DE)
(74) Representative: Pjanovic, Ilija

(57) **Abstract**

A semiconductor device comprising an interconnect, wherein said interconnect is arranged to transfer current from one terminal to another, wherein said interconnect comprises a first layer comprising a plurality of interweaved fingers, wherein each of said interweaved fingers varies in width in a direction of propagation current thereby resulting in a difference of resistance within each of said interweaved fingers in said direction of propagation of current; a second layer arranged below said first layer, characterized in that said second layer compensates said difference of resistance in said first layer.

## Description

### Technical Field

The present application generally relates to the field of electronic devices and more specifically to a semiconductor device that allows for high current transfer in electronic devices.

### Background

Multi-finger structures are commonly used for a certain class of devices; especially for devices that have a lateral current direction and are limited by the edge length of the contacts and do not scale with the contact area. Such multi-finger structures often are limited by the current capacity of the interconnect (metal) fingers.

To achieve a well-balanced current distribution throughout the whole length of the fingers, it is necessary to have an identical resistance for all possible current paths. Usually this necessitates that the interconnect fingers are of equal width over the whole length of the fingers. In most cases, the width is identical for all fingers.

The limiting part of the interconnect fingers is the base of the finger, where the current density is highest. At the far end of the interconnect finger the current density is much smaller.

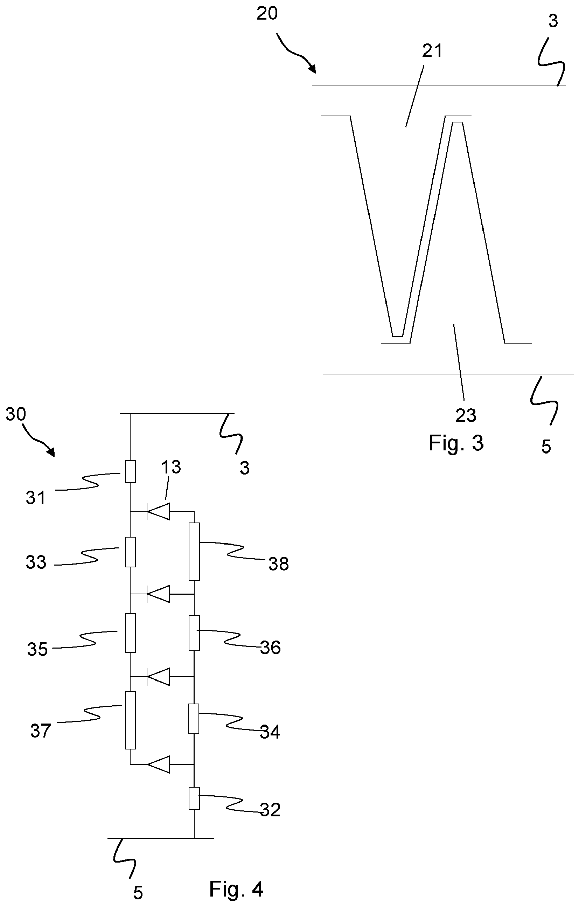

It has been proposed by US patent application US 20040016971 to use interconnect fingers with varying width: wide at the base and small at the far end. Such structures are also known as pyramidal fingers. This shape reduces the current density at the base of the fingers. However, the result is that the current distribution becomes less uniform: the current path that uses half the length of an input metal finger and half the length of an output metal finger will have a lower resistance than any other current path. This is also illustrated and described in Fig. 4 of the present application. This again limits the total current capacity of the whole device because when in the middle of the fingers the critical current density of the silicon is reached, the outer parts will carry less current than the critical current.

Such pyramidal fingers are also known from other documents such US patent US6518604 and German utility model application DE 102005047409. In some cases, as in the German utility model application, the multi finger pyramidal shaped structures are used in a high frequency capacitor for constant voltage distribution.

US patent US8304807 discloses a top and bottom layer approach in capacitors. However, the width of the fingers in both the layers in constant.

### Summary

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

A first aspect of the present disclosure, relates to a semiconductor device comprising an interconnect, wherein said interconnect is arranged to transfer current from one terminal to another, wherein said interconnect comprises a first layer comprising a plurality of interweaved fingers, wherein each of said interweaved fingers varies in width in a direction of propagation of current thereby resulting in a difference of resistance in each of said interweaved fingers in said direction of propagation of current; a second layer arranged below said first layer, characterized in that said second layer is arranged to compensate said difference of resistance in said first layer.

Firstly, two layers of interconnect are used. The first and the second layer may transport the current in perpendicular directions. As will be explained in the subsequent sections, the shape of the fingers creates different resistance paths which in turn results in a non-uniform distribution of current. The skilled person understands that the difference in resistance is related to different paths in which the current may propagate between the two terminals. Primarily, the difference in resistance that occurs as a result of the shape of the interweaved fingers is of interest. Furthermore, the term "terminal" as used throughout the present disclosure may also be interchangeably used within the context of the present application with "electrode".

In the context of the present disclosure, the term "interweaved fingers" is understood to mean alternately placed input and output finger structures that are arranged such that it allows for propagation of current between the input and the output electrodes. This is also clearly understood from the figures and the description in subsequent sections.

As will be explained in subsequent sections, the non-uniform distribution of current is not desirable as it limits the current carrying capacity. In order to ensure uniform current distribution, a second, lower, or bottom layer is added. The skilled person understands, that when only one layer of interconnect is used, this layer is in contact with the semiconductor layer. This will be made evident from the drawings and the corresponding description thereof.

When a second layer, according to the present disclosure, is employed, this second, bottom layer may be disposed in between the primary interconnect layer comprising the plurality of interweaved fingers and the semiconductor layer. Since this can be considered to be below the first, or, top layer, the term "bottom layer" has been used interchangeably with the "second layer".

Secondly, the top layer fingers have varying width along their length, preferably being widest at the base and smallest at the far end. This creates the difference in resistance along the direction of propagation of current.

Thirdly, the bottom layer is arranged such that it compensates for the difference in resistance in the top layer in use of the device. The primary aim of the bottom layer is to compensate for the difference in resistance in the top layer. A few examples of how this can be achieved are elaborated further below. The second, or bottom layer, may, for example, be arranged such that all possible current paths between the input and the output electrode have the exact same resistance. Alternately, the second, or bottom layer may be arranged so as to reduce the difference in resistance between the current paths in the first layer, thereby resulting in a more uniform distribution of current.

According to an example, the second layer comprises a plurality of strips arranged perpendicular to said direction of propagation of current, wherein the widths of the strips vary so as to compensate for the difference of resistance in said first layer.

In an example, the width of the bottom layer strips is smaller in the centre of the device than in the outer region of the device, wherein outer region means at or near the bases and far ends of the fingers. The different widths of the interconnect strips in the second, or, bottom layer result in different resistances in those parts of the current paths where the current propagates through the strips. Said widths are chosen such that they compensate the resistance differences in the top layer. As a result, all current paths have the same resistance and the total current capacity is maximized. Within the context of the present disclosure, the strips of the second, or, bottom layer may also be referred to as lines.

According to an exemplary embodiment, a physical property of the second layer is varied in the direction of current propagation so as to compensate the resistance difference in said first layer. The skilled person understands that using a plurality of strips of varying width in the bottom layer is not the only option. The resistance compensation may alternatively, or in combination with strips of varying width, be achieved, for example, by varying a physical property of the bottom layer. This physical property may be, for example, a resistivity of the bottom layer or an internal resistance of the semiconductor/Silicon layer.

According to an example, both said first, and second layers are metallic.

In an exemplary embodiment, the plurality of interweaved fingers in said first layer have a pyramidal shape. Such a shape is known in the prior art.

According to an example, the semiconductor device is any of a:
- ESD diode;
- TVS diode;
- lateral MOSFET.

The skilled person understands that this style of interconnect may, in principle, be used for any device that demands a uniform, high current carrying capacity.

### Brief description of the drawings

Fig. 1 shows a multi-finger structure as known in the prior art.
Fig. 2 shows a schematic model of the structure as shown in Fig. 1.
Fig. 3 shows another multi-finger structure as known in the prior art.
Fig. 4 shows a schematic model of the structure as shown in Fig. 3
Fig. 5 shows a multi-finger structure according to the present disclosure.
Fig. 6 shows a schematic model of the structure as shown in Fig. 5
Fig. 7 shows a layout of a device according to the present disclosure.

### Detailed Description

The ensuing description above provides preferred exemplary embodiment(s) only, and is not intended to limit the scope, applicability or configuration of the invention. Rather, the ensuing description of the preferred exemplary embodiment(s) will provide those skilled in the art with an enabling description for implementing a preferred exemplary embodiment of the invention, it being understood that various changes may be made in the function and arrangement of elements, including combinations of features from different embodiments, without departing from the scope of the invention.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

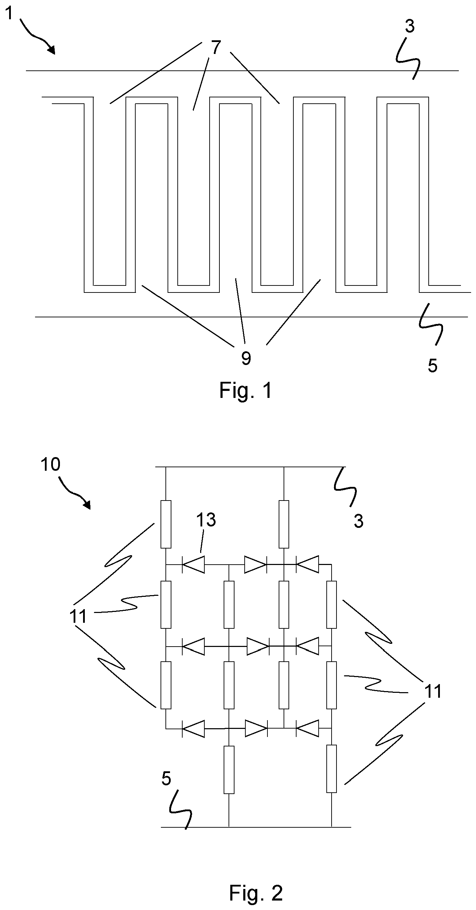

Fig. 1 shows a multi-finger structure as known in the prior art. Reference number 1 indicates a device comprising a multi-finger structure, wherein current needs to be transferred between two electrodes 3 and 5. It is assumed that the direction of current flow is from electrode 5 to electrode 3. The structure comprises a plurality of fingers 7 connected to electrode 3 and a plurality of fingers 9 connected to electrode 5.

Since the fingers are of equal width, they offer a uniform resistance to the current flow path. This is further understood from the schematic model 10 of the device as shown in Fig. 2. The skilled person appreciates that the model as shown in Fig. 2 is a simplified diagram and models the resistance in discrete values rather than in a continuous manner. All the resistances 11 are considered to be of equal value. For example, the resistances 11 on the left end of Fig. 2 model the resistance of one of the fingers 7, and the resistances 11 on the right end of Fig. 2 model the resistance of one of the fingers 9. The skilled person appreciates that there may exist many more branches depending on the number of fingers as shown in Fig. 1. Only a small portion thereof is visualized and modelled in Fig.2. Furthermore, the resistance block in the inner two branches shown in Fig. 2 are also modelled to be the same as resistance 11, For ease of viewing the figure, these have not been labelled as such. Since there is a small separation between the fingers 7 and 9, wherein current has to traverse through the semiconductor material, the resistance of the semiconductor material is modelled as a diode 13.

The skilled person understands that irrespective of the current flow path from electrode 5 to electrode 3, the total path resistance for each path remains the same. Thus, although current flow will be uniform over all paths, the amount of current that can be carried is limited by the width at the base of the finger.

Fig. 3 shows another multi-finger structure 20 as known in the prior art. As can be clearly understood, the key difference between the structure 1 shown in Fig. 1 and the structure 20 shown in Fig. 3 is that the fingers 21, 23 have a varying width in the direction of propagation of current. It is understood that the structure may comprise of more fingers extending in both directions, and for the purposes of simplicity only one finger of each electrode 3;5 is shown.

Fig. 4 shows a schematic model 30 of the structure as shown in Fig. 3. It is understood that the assumptions and simplifications that have been made while depicting the model in Fig.2 are also applied here. That is, the resistances of the fingers have been discretized and the resistance of the semiconductor material has been modelled as a diode. However, since the width of the fingers varies, the values of the resistances are also different. This is visually illustrated by changing the size of the resistance blocks. The bigger the block, the higher the resistance.

For example, when considering finger 23 of electrode 5, the resistance 32, 34, 36, 38 are in an increasing order of size. This implies that resistance 38 is higher than resistance 36, which is, in turn, higher than resistance 34, which is higher than resistance 32. This also corresponds with the structure of the finger since it has wide base corresponding with a low resistance 32 and a narrow top corresponding to a high resistance 38. A similar consideration can be made for resistances 31, 33, 35 and 37 of finger 21 of electrode 3.

It is further understood that the two fingers 21 and 23 are identical in size, and differ only in orientation. Hence, the resistances 31 and 32 are equal, resistances 33 and 34 are equal, resistances 35 and 36 are equal and finally resistances 37 and 38 are equal. For example, Resistance 31 = 32 = 0.5 Ω (Ohms)
Resistance 33 = 34 = 1 Ω (Ohms)
Resistance 35 = 36 = 2 Ω (Ohms)
Resistance 37 = 38 = 4 Ω (Ohms)

The skilled person understands that these values used are merely exemplary and do not necessarily reflect the actual values in a structure. In such a structure as shown in Fig. 4, there are a plurality of paths the current can propagate through. These paths are described here one by one. In all the paths, a current direction from electrode 5 to electrode 3 is considered. The paths are identified by the resistances that the current flows through. For each path, the total resistance is also calculated.
Path A: 32 - 37 - 35 - 33 - 31; Total resistance = 8 Ω (Ohms)
Path B: 32 - 34 - 35 - 33 - 31; Total resistance = 5 Ω (Ohms)
Path C: 32 - 34 - 36 - 33 - 31; Total resistance = 5 Ω (Ohms)
Path D: 32 - 34 - 36 - 38 - 31; Total resistance = 8 Ω (Ohms)

Although four paths have been described for this exemplary model, it is seen that paths A and D offer a greater resistance (8 Ohms) compared to paths B and C (5 Ohms). This would mean that current would primarily flow through the middle of the structure, and not flow on the outer periphery of the structure. This would result in a device without a uniform current distribution.

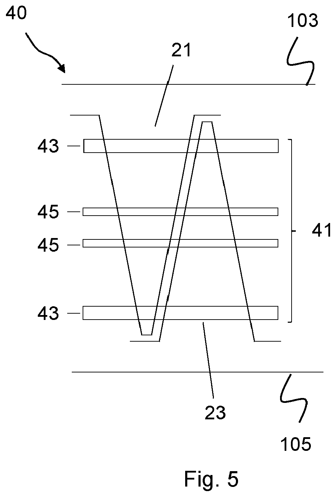

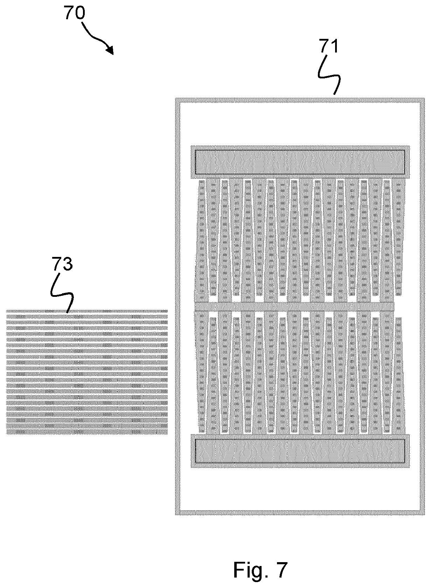

Fig. 5 shows a multi-finger structure 40 according to the present disclosure. To overcome the problem of non-uniform current distribution as highlighted, the present application proposes the use of a second layer of interconnect 41 between two electrodes 103 and 105. The purpose of the second layer of interconnect 41 is to compensate for the difference in resistance in the first layer. In an embodiment, this is achieved by plurality of horizontal strips 43, 45. For purposes of simplicity only 2 sets of strips 43; 45 are shown. An actual layout can be visualized in Fig. 7. It is understood that the fingers 21 and 23 may have been formed as one integral part with electrode 103 or 105 respectively, or may be connected to, by suitable means to the respective electrode, wherein said connection is such that it allows for propagation of current between the finger and the electrode.

The width of the strips in the bottom layer is smaller in the centre than in the outer regions. For example, the width of strip 45 is smaller than the width of strip 43. This would mean that the resistance of the strip 45 is much higher than that of the strip 43. This difference in resistance compensates for the difference of resistance in the top layer. As a result, uniform distribution of current can be achieved. The skilled person understands that measures other than the width of the strips in the second layer could be used for resistance compensation. As an example, the inner resistance of the silicon structure, modelled as a diode, might be adjusted. Alternately, parameters or properties other than the width of the strip could be adjusted to achieve the required resistance compensation. For example, materials of different resistivity could be employed so as to achieve the requires resistance compensation.

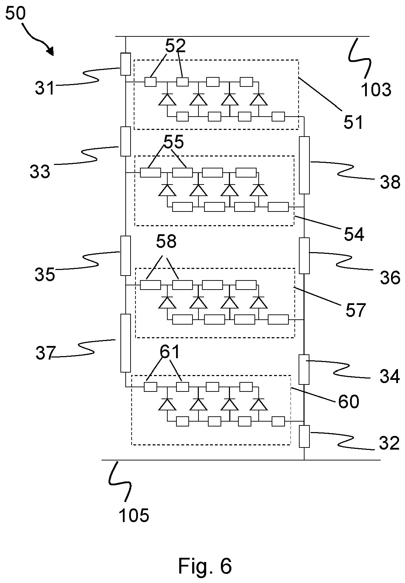

The skilled person also understands that the values of the resistance in the bottom layer may be chosen such that they compensate the resistance differences in the top metal layer. As a result, all current paths have the same resistance and the total current capacity is maximized. This is further elaborated with the schematic model 50 shown in Fig. 6.

The model 50 is similar to the model 30 shown in Fig. 4 with the exception of blocks 51, 54, 57, and 60. These blocks serve the purpose of modelling the bottom layer which compensates for the resistance difference in the top layer. For the purpose of elaborating with numerical examples, the values of resistance 31 - 38 are considered to be the same as in the previous example. It is further understood that blocks 51 and 60 are identical and blocks 54 and 57 are identical. Furthermore, the previous explanation regarding the visual size of the resistance blocks is valid for this example as well.

As an example, resistances 52 in block 51 and resistances 61 in block 60 are assumed to have a value of 0.2 Ohms each. Resistances 55 in block 54 and resistances 58 in block 57 are assumed to have a value of 0.9 Ohms each. This corresponds with the physical reality since the width of the strips in the centre is much smaller than the width of the strips at the outer peripheries. This results in a higher resistance in the centre, and hence the higher value for resistances 55 and 58.

At least four current paths E - H can be observed. The path and the total resistance values are described here below. The skilled person understands that although multiple current paths are possible within each of the blocks 51, 54, 57 and 60, each of these paths offer the same amount of resistance. Hence, for the purpose of simplicity, these alternatives are considered as one single path.
Path E: 32 - 60 - 37 - 35 - 33 - 31; Total resistance = 9.5 Ω (Ohms)
Path F: 32 - 34 - 57 - 35 - 33 - 31; Total resistance = 9.5 Ω (Ohms)
Path G: 32 - 34 - 36 - 54 - 33 - 31; Total resistance = 9.5 Ω (Ohms)
Path H: 32 - 34 - 36 - 38 - 51 - 31; Total resistance = 9.5 Ω (Ohms)

Thus, with these chosen values, it is seen that all four paths offer the same resistance and hence current is equally likely to flow through each of these available paths. As a result, current distribution will be uniform resulting in a higher current carrying capacity.

Fig. 7 shows a layout 70 of a device according to the present disclosure. For ease of understanding, the top layer 71 and bottom layer 73 are shown next to one another, instead of one on top of the other which is how they are actually present in the device. The top layer 71 has a plurality of interweaved fingers 21 and 23 as shown in Fig. 5. The bottom layer 73 is a layer like layer 41 comprising a plurality of strips 43; 45. Each of the strips in the bottom layer has a constant width throughout its length, but the width of each strip is different from that of its neighbouring ones. More specifically, the width of the strips is the smallest in the middle and is the largest at the outer edges.

## Claims

1. A semiconductor device comprising an interconnect, wherein said interconnect is arranged to transfer current from one terminal to another, wherein said interconnect comprises:
- a first layer comprising a plurality of interweaved fingers, wherein each of said interweaved fingers varies in width in a direction of propagation of current thereby resulting in a difference of resistance in each of said interweaved fingers in said direction of propagation of current;
- a second layer arranged below said first layer,
**characterized in that** said second layer is arranged to compensate said difference of resistance in said first layer.

2. Semiconductor device according to claim 1, wherein said second layer comprises a plurality of strips arranged perpendicular to said direction of propagation of current, wherein the width of the strips vary so as to compensate the resistance difference in said first layer.

3. Semiconductor device according to any one of the previous claims, wherein a physical parameter of the second layer is varied in the direction of propagation of current so as to compensate the resistance difference in said first layer.

4. Semiconductor device according to any one of the previous claims, wherein both said first, and second layers are metallic.

5. Semiconductor device according to any one of the previous claims wherein said plurality of interweaved fingers in said first layer have a pyramidal shape.

6. Semiconductor device according to any one of the previous claims, wherein said semiconductor device is any of a:
- ESD diode;
- TVS diode;
- lateral MOSFET.
